# EUROPEAN PATENT APPLICATION

(11) **EP 2 363 688 A2**
(43) Date of publication of application: **07.09.2011**
(21) Application number: 11001746.4
(22) Date of filing: 02.03.2011
(51) Int. Cl.: G01C 17/38, G01R 33/025

(54) **Magnetic data processing device, method, and program**

(30) Priority: 02.03.2010 JP 2010045113; 23.02.2011 JP 2011036782
(71) Applicant: Yamaha Corporation, Hamamatsu-shi, Shizuoka-ken 430-8650 (JP)
(72) Inventor: Handa, Ibuki, Hamamatsu-shi, Shizuoka-ken, 430-8650 (JP)
(74) Representative: Klang, Alexander H.

(57) **Abstract**

In a magnetic data processing device, an input part sequentially receives magnetic data qᵢ output from a magnetic sensor. A storage part sequentially stores the magnetic data received through the input part. An offset derivation part derives an offset according to a probabilistic method using a plurality of the magnetic data stored in the storage part as a statistical population. The offset derivation part assumes that an error Apᵢ contained in each of the magnetic data qᵢ is a random variable vᵢ following a probability distribution µ and uses an expected value corresponding to the probability distribution µ for deriving the offset. Specifically, the offset derivation part calculates an index representing variance of distances from the offset to respective ones of true magnetic data that are obtained by subtracting each Δp₁ from each magnetic data qᵢ of the statistical population, and derives the offset which minimizes the expected value of the calculated index.

## Description

### BACKGROUND OF THE INVENTION

### [Technical Field of the Invention]

The present invention relates to a magnetic data processing device, method, and program, and more particularly to a technology for correcting an offset of a magnetic sensor.

### [Description of the Related Art]

A conventional magnetic sensor is mounted on a moving body such as a mobile phone or a vehicle to detect the direction of the Earth's magnetic field (geomagnetism). A 3D magnetic sensor generally includes 3 magnetic sensor modules to decompose the magnetic force (or magnetic field) into components of 3 orthogonal directions. Magnetic data output from the 3D magnetic sensor consists of a combination of outputs of the 3 magnetic sensor modules and thus it is 3D vector data that is a linear combination of mutually orthogonal unit vectors. The direction and magnitude of the magnetic data correspond to the direction and magnitude of a magnetic field detected by the 3D magnetic sensor. When specifying the direction or magnitude of the Earth's magnetic field based on outputs of the magnetic sensor, it is necessary to perform a process for correcting the outputs of the magnetic sensor in order to negate measurement errors caused by magnetization of the moving body. A control value of this correction process is referred to as an "offset". The offset is vector data indicating a magnetic field component caused by the magnetization components of the moving body detected by the magnetic sensor. Such measurement errors are negated by subtracting the offset from the magnetic data output from the magnetic sensor. It is possible to calculate the offset by obtaining the center of a sphere on which a set of magnetic data is distributed when a 3D magnetic sensor is used or by obtaining the center of a circle on which a set of magnetic data is distributed when a 2D magnetic sensor is used.

Japanese Patent Application Publication No. 2007-240270 describes an offset correction method. Directions in which the offset is corrected are restricted according to the form of distribution of the magnetic data set, thereby allowing the offset to approach a true offset even when the distribution of the magnetic data set is narrow.

However, each magnetic data sample of the offset-corrected magnetic data set may contain an error even when the offset is a true offset. The reasons are that outputs of the magnetic sensor inherently have measurement errors following Gaussian distribution, a magnetic field measured by the magnetic sensor varies during a period in which magnetic data required to calculate the offset is stored, since there is no completely uniform magnetic field in practice, and calculation errors occur until digital values are acquired from the outputs of the magnetic sensor. That is, each magnetic data sample qᵢ (1 = 1, 2, ... ) is the sum of a true value pᵢ and an error Δpᵢ which is not associated with the offset. That is, the magnetic sensor outputs the sum (q₁ = pᵢ + Δpᵢ) as the magnetic data qᵢ. The true offset corresponds to the center of a circle or sphere on which true values pᵢ are distributed.

However, the magnetic data q₁ cannot be separated into the true value pᵢ and the error Apᵢ and thus it is assumed in the conventional offset correction method that the Δpᵢ is zero although it is not certain that the Δpᵢ is zero. Therefore, the offset derived using the conventional offset correction method is different from the true offset.

### SUMMARY OF THE INVENTION

Thus, it is an object of the invention to provide a magnetic data processing device, method and program which can correctly derive an offset from a stored magnetic data set.

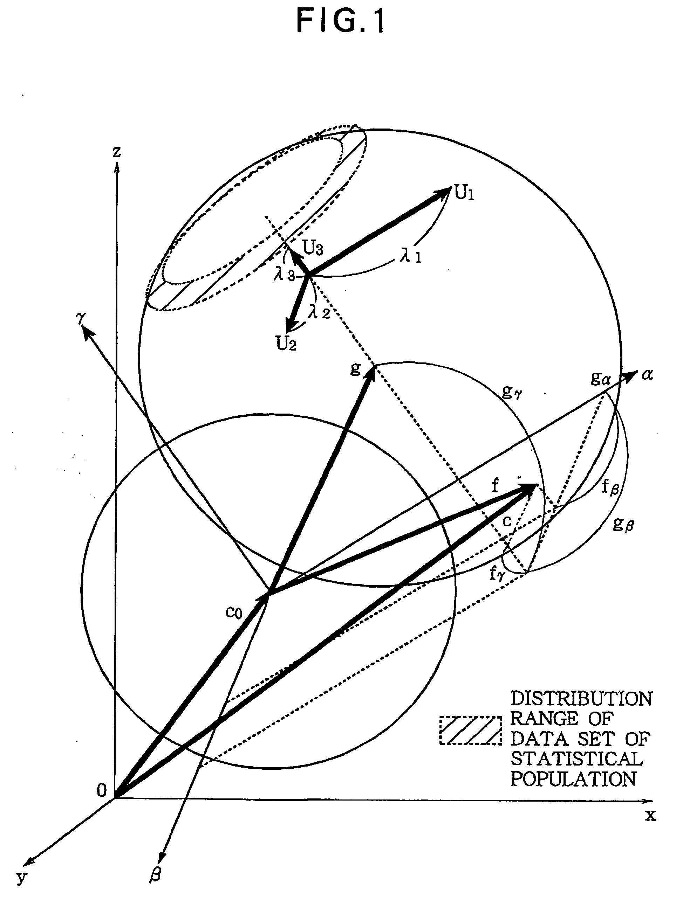

(1) In accordance with an aspect of the invention, the above object can be achieved by the provision of a magnetic data processing device including an input part that sequentially receives magnetic data qᵢ output from a magnetic sensor, a storage part that sequentially stores the magnetic data received through the input part, and an offset derivation part that derives an offset according to a probabilistic method using a plurality of the magnetic data stored in the storage part as a statistical population, wherein the offset derivation part derives the offset using an expected value corresponding to a probability distribution µ while assuming that an error Δpᵢ included in each of the plurality of the magnetic data is a random variable vᵢ following the probability distribution µ.
   According to the invention, it is possible to correctly derive the offset since, when the offset is derived from a statistical population including a plurality of magnetic data (or magnetic data samples) according to a probabilistic method, an expected value corresponding to the probability distribution µ is used while an error Δpᵢ, which is included in each of the plurality of magnetic data regardless of the offset, is assumed as a random variable v₁ following the probability distribution µ. Specifically, in a procedure by which an offset is derived using a probabilistic calculation assuming that the magnetic data qᵢ. (i = 1, 2, ...) is the sum of a true value pᵢ and an error vᵢ corresponding to the probability distribution µ, a term including the error vᵢ, which is the random variable, is substituted with an expected value corresponding to the probability distribution µ. This makes it possible to derive a correct offset, in which the tendency (or a probability distribution) of the error vᵢ that is not associated with the offset is reflected.
(2) When an offset of the magnetic sensor is derived according to a probabilistic method using a plurality of magnetic data as a statistical population, it is possible to derive the offset as a solution to a mathematical programming problem. When a probabilistic element is included in a coefficient of an objective function in a mathematical programming problem, the problem may be considered a probabilistic programming problem. To correctly derive the offset as a solution to the mathematical programming problem, it Is necessary to define the objective function using the error Δpᵢ. That is, the mathematical programming problem for correctly deriving the offset of the magnetic sensor is a stochastic model. Even though the mathematical programming problem for deriving the offset of the magnetic sensor is inherently a stochastic model, the mathematical programming problem has been conventionally handled as a deterministic model since the true value and the error which is not associated with the offset cannot be separated. By substituting a term including an error vᵢ, which is a random variable, included in an objective function defined to derive the offset as a solution to the probabilistic programming problem, with an expected value corresponding to the probability distribution µ, the stochastic model can be replaced with a deterministic model to derive the solution. Thus, by deriving the solution to the mathematical programming problem that is replaced with the deterministic model using the expected value, it is possible to derive a correct offset in which the tendency (or a probability distribution) of the error vᵢ that is not associated with the offset is reflected.
   In the magnetic data processing device for achieving the above object, the offset derivation part may calculate an index representing variance of distances from an offset to respective ones of true magnetic data that are obtained by subtracting each error Δpᵢ from each magnetic data go of the statistical population, and derive the offset which minimizes the expected value of the calculated index.
(3) Further, the offset derivation part may calculate the index in the form of a real-valued function fᵥ(c), and assuming that an expected value of the real-valued function fv(c) is a function f(c), the derivation part may obtain the function f(c) by substituting a term of the real-valued function fᵥ(c) containing the random variable vᵢ which is time-independent, with its expected value corresponding to the probability distribution µ, and derive, as the offset, c which minimizes the function f(c) obtained by substitution using the expected value corresponding to the probability distribution µ.
(4) When magnetic data qᵢ is expressed as q₁ = p₁ + v₁ (i = 1, 2, ...), dᵢ is defined as the square of the distance between the true value p₁ and the offset c, i.e., the square of the radius of a sphere or a circle on which the statistical population is distributed. The value of d₁ is expressed as follows. ${d}_{i} = {‖ \left({q}_{i}-{v}_{i}\right) - c ‖}^{2}$
   Here, when the average of dᵢ is defined as in Expression 2, a real-valued function fᵥ(c) expressed in Expression 3 is an index of the variance of dᵢ. $\overline{d} = \frac{1}{n} {\sum }_{i = 1}^{n} {d}_{i}$ ${f}_{v} \left(c\right) = \frac{1}{4} {\sum }_{i = 1}^{n} {\left({d}_{i}-\overline{d}\right)}^{2}$
   The value "c" which minimizes the function fᵥ(c) as an index of the variance of d₁ can be considered the most probable new offset.
   The right-hand side of Expression 3 can be rewritten as Expression 5 when *q̅* , *v̅* , Xᵥ, Rᵥ, and jᵥ are defined as Expression 4. $\begin{matrix}\overline{q} = \frac{1}{n} {\sum }_{i = 1}^{n} {q}_{i} \\ \overline{v} = \frac{1}{n} {\sum }_{i = 1}^{n} {v}_{i} \\ {X}_{v} = \left[\begin{matrix}{\left\{\begin{matrix}\left({q}_{1}-{v}_{1}\right) - \left(\overline{q}-\overline{v}\right)\end{matrix}\right\}}^{T} \\ ⋮ \\ {\left\{\begin{matrix}\left({q}_{n}-{v}_{n}\right) - \left(\overline{q}-\overline{v}\right)\end{matrix}\right\}}^{T}\end{matrix}\right] \\ {R}_{v} = \frac{1}{n} {\sum }_{i = 1}^{n} {\left({q}_{i}-{v}_{i}\right)}^{T} ⁢ \left({q}_{i}-{v}_{i}\right) \\ {j}_{v} = \frac{1}{2} ⁢ \left[\begin{matrix}{\left({q}_{1}-{v}_{1}\right)}^{T} ⁢ \left({q}_{1}-{v}_{1}\right) - {R}_{v} \\ ⋮ \\ {\left({q}_{n}-{v}_{n}\right)}^{T} ⁢ \left({q}_{n}-{v}_{n}\right) - {R}_{v}\end{matrix}\right]\end{matrix}$ $\frac{1}{4} {\sum }_{i = 1}^{n} {\left({d}_{i}-\overline{d}\right)}^{2} = {c}^{T} \left({X}_{v}^{T}⁢{X}_{v}\right) ⁢ c - 2 ⁢ {\left({X}_{v}^{T}⁢{j}_{v}\right)}^{T} ⁢ c + {j}_{v}^{T} ⁢ {j}_{v}$
   Therefore, in the magnetic data processing device for achieving the above object, the real-valued function fᵥ(c) may also be expressed as follows. ${F}_{v} \left(c\right) = {c}^{T} \left({X}_{v}^{T}⁢{X}_{v}\right) ⁢ c - 2 ⁢ {\left({X}_{v}^{T}⁢{j}_{v}\right)}^{Y} ⁢ c + {j}_{v}^{T} ⁢ {j}_{v}$
   An error Δp₁, which is not associated with the offset of a practical magnetic sensor, may be approximated by a time-independent random variable vᵢ following a normal distribution whose average is 0 and whose variance-covariance matrix is expressed by "V" and is also time independent.
   In the magnetic data processing device for achieving the above object, the value c which minimizes the objective function fᵥ(c) without a constraint condition may be obtained, assuming that the error vᵢ is a time-independent random variable following the normal distribution whose average is 0 and whose variance-covariance matrix is expressed by "V". That is, in the magnetic data processing device for achieving the above object, when A' is positive definite, the offset derivation part may output, as the offset, c expressed as follows : $c = {Aʹ}^{- 1} \left\{{X}^{T}⁢j-\left(n-1\right)⁢V⁢\overline{q}\right\}$
   or $c = {Aʹ}^{- 1} ⁢ {X}^{T} ⁢ jʹ + \overline{q}$
   where $\begin{matrix}X = \left[\begin{matrix}{\left({q}_{1}-\overline{q}\right)}^{T} \\ ⋮ \\ {\left({q}_{n}-\overline{q}\right)}^{T}\end{matrix}\right] \\ R = \frac{1}{n} {\sum }_{i = 1}^{n} {q}_{i}^{T} ⁢ {q}_{i} \\ j = \frac{1}{2} ⁢ \left[\begin{matrix}{q}_{1}^{T} ⁢ {q}_{1} - R \\ ⋮ \\ {q}_{n}^{T} ⁢ {q}_{n} - R\end{matrix}\right] \\ Rʹ = \frac{1}{n} {\sum }_{i = 1}^{n} {\left({q}_{i}-\overline{q}\right)}^{T} ⁢ \left({q}_{i}-\overline{q}\right) \\ jʹ = \frac{1}{2} ⁢ \left[\begin{matrix}{\left({q}_{1}-\overline{q}\right)}^{T} ⁢ \left({q}_{1}-\overline{q}\right) - Rʹ \\ ⋮ \\ {\left({q}_{n}-\overline{q}\right)}^{T} ⁢ \left({q}_{n}-\overline{q}\right) - Rʹ\end{matrix}\right] \\ A = {X}^{T} ⁢ X \\ Aʹ = A - \left(n-1\right) ⁢ V\end{matrix}$
(5, 6) The following function fᵥ(c) is an index of the variance of dᵢ . ${f}_{v} \left(c\right) = \frac{1}{4} {\sum }_{i = 1}^{n} {\left({d}_{i}-\overline{d}\right)}^{2} = {c}^{T} \left({X}_{v}^{T}⁢{X}_{v}\right) ⁢ c - 2 ⁢ {\left({X}_{v}^{T}⁢{j}_{v}\right)}^{T} ⁢ c + {j}_{v}^{T} ⁢ {j}_{v}$
   It is possible to derive a correct offset by deriving c which minimizes the function fᵥ(c) that is an index of the variance of dᵢ. However, when the statistical population is unevenly distributed near a specific plane or line, derivation of the offset without correction in a direction normal to the specific plane or line is more likely to correctly derive the offset. Therefore, the amount of correction of the offset in the direction normal to the specific plane or line may be restricted according to the extent to which the statistical population is unevenly distributed near the specific plane or line. A principal value(s) of the distribution of the statistical population may be used as an index representing the extent to which the statistical population is unevenly distributed near the specific plane or line.
   That is, in the magnetic data processing device for achieving the above object, the offset derivation part may derive, as the offset, c which minimizes an objective function f(c) under a constraint condition, the objective function f(c) being obtained from a real-valued function fᵥ(c), which is defined for the statistical population and includes the random variable vᵢ, by substituting a term containing the random variable vᵢ in the real-valued function fᵥ(c) with its expected value corresponding to the probability distribution µ.
   In addition, in the magnetic data processing device for achieving the above object, the real-valued function fᵥ(c) may be expressed as follows: ${f}_{v} \left(c\right) = {c}^{T} \left({X}_{v}^{T}⁢{X}_{v}\right) ⁢ c - 2 ⁢ {\left({X}_{v}^{T}⁢{j}_{v}\right)}^{T} ⁢ c + {j}_{v}^{T} ⁢ {j}_{v}$
   where $\begin{matrix}\overline{q} = \frac{1}{n} {\sum }_{i = 1}^{n} {q}_{i} \\ \overline{v} = \frac{1}{n} {\sum }_{i = 1}^{n} {v}_{i} \\ {X}_{v} = \left[\begin{matrix}{\left\{\begin{matrix}\left({q}_{1}-{v}_{1}\right) - \left(\overline{q}-\overline{v}\right)\end{matrix}\right\}}^{T} \\ ⋮ \\ {\left\{\begin{matrix}\left({q}_{n}-{v}_{n}\right) - \left(\overline{q}-\overline{v}\right)\end{matrix}\right\}}^{T}\end{matrix}\right] \\ {R}_{v} = \frac{1}{n} {\sum }_{i = 1}^{n} {\left({q}_{i}-{v}_{i}\right)}^{T} ⁢ \left({q}_{i}-{v}_{i}\right) \\ {j}_{v} = \frac{1}{2} ⁢ \left[\begin{matrix}{\left({q}_{1}-{v}_{1}\right)}^{T} ⁢ \left({q}_{1}-{v}_{1}\right) - {R}_{v} \\ ⋮ \\ {\left({q}_{n}-{v}_{n}\right)}^{T} ⁢ \left({q}_{n}-{v}_{n}\right) - {R}_{v}\end{matrix}\right]\end{matrix}$
   wherein the storage part may sequentially store a plurality of the magnetic data in order to update an old offset of the magnetic data with a new offset, and the offset derivation part may derive the new offset based on the old offset and the statistical population under the constraint condition that the new offset be obtained as the sum of the old offset and a correction vector that is a linear combination of a set of fundamental vectors in principal axis directions of distribution of the statistical population, respective coefficients of the linear combination of the fundamental vectors being obtained by weighting, according to principal values of the distribution of the statistical population, respective coefficients of a position vector of a temporary offset, derived from the statistical population without using the old offset, relative to the old offset, the position vector of the temporary offset being a linear combination of the fundamental vectors.
   An algorithm used in this device is described below in detail with reference to FIG. 1. Key points of this algorithm are that a magnetic data set distributed in a principal axis direction with larger dispersion is estimated to be more significant statistical population elements for use in updating the offset and a magnetic data set distributed in a principal axis direction with smaller dispersion is estimated to be less significant statistical population elements for use in updating the offset. Details are as follows. Each of the old offset c₀. the new offset c, and the temporary offset, which corresponds to the position vector of the end point of "g" relative to the point of origin "0", is 3D position vector data that is a linear combination of a fundamental vector set of magnetic data. The new offset c is derived based on the old offset c₀ and a magnetic data set that is stored to update the old offset c₀ with the new offset c.

The statistical population, which includes a plurality of magnetic data stored to update the old offset with the new offset c, may include a magnetic data set that has been stored over a predetermined period of time and may includes a magnetic data set including a predetermined number of magnetic data samples and may also include a magnetic data set including any number of magnetic data samples that has been stored at a certain time (for example, at the time when an offset update request is made).
The old offset c₀ may be derived using the same method as the new offset c and may also be predetermined.

Although the temporary offset is defined as being derived from the statistical population without using the old offset c₀, this definition is introduced to define the constraint condition under which the new offset c is derived and the temporary offset is actually not data necessary to derive. If the temporary offset is actually derived from the statistical population without using the old offset c₀, the temporary offset is a position vector of the center of a sphere near which the statistical population is distributed. However, if the statistical population is unevenly distributed at a portion of the sphere derived from the statistical population, an error included in each element of the statistical population greatly affects the derivation result of the sphere and thus there is a possibility that a temporary offset distant from the true offset is derived. Let us consider, for example, that a statistical population has a toroidal distribution with mutually orthogonal eigenvectors u₁, u₂, and u₃ and the variance of the statistical population is minimized in the direction of the eigenvector u₃ corresponding to the minimum principal value as shown in FIG. 1. In this case, since the variance of the statistical population is small in the direction of the eigenvector u₃ of the distribution, there is a high probability that the position of a temporary offset derived from the statistical population is distant from the position of the true offset in the direction of the eigenvector u₃. On the other hand, in this case, since the variance of the statistical population is large in the direction of the eigenvector u₁ of the distribution, there is a high probability that the position of the temporary offset derived from the statistical population is near the position of the true offset in the direction of the eigenvector u₁.

Since the variances in the principal axis directions of the distribution can be expressed using the principal values λ₁, λ₂, and λ₃ of the distribution as indicators of the distribution, this device estimates the statistical population distributed in the directions corresponding respectively to the principal values according to the principal values λ₁, λ₂, and λ_{3.} In this specification, the principal values correspond to eigenvalues of a matrix obtained by subtracting a variance-covariance matrix of errors from a variance-covariance matrix of measured values. Specifically, first, a correction vector f, which is a position vector of the new offset c relative to the old offset c₀. and a position vector g of the temporary offset relative to the old offset c₀ can be defined in a coordinate system having coordinate axes a, B, and Y coincident with the principal axis directions of the distribution. That is, each of the correction vector f and the position vector g can be defined to be a linear combination of fundamental vectors of the principal axis directions of the distribution. This corresponds to conversion into principal axis values. If the components fₐ, f_{B}, and f_{γ} of the correction vector f are derived by weighting the components gₐ, g_{B}, and g_{γ} of the position vector g of the temporary offset relative to the old offset c₀ according to the measures of the corresponding principal values u₁, u₂ , and u₃ of the distribution, it is possible to derive the correction vector f by increasing the reliability of the statistical population in directions with large dispersion and decreasing the reliability of the statistical population in directions with small dispersion. However, such definitions of the correction vector f and the position vector g are also introduced to define the constraint condition under which the new offset c is derived and it is not actually necessary to derive the correction vector f and the position vector g.

By deriving the new offset c under a constraint condition that the new offset c be obtained as the sum of the old offset c₀ and the correction vector f defined as described above, it is possible to update the old offset with the more probable new offset, regardless of whether or not the distribution of the statistical population is biased, while estimating that a magnetic data set distributed in a principal axis direction with larger dispersion is a more significant statistical population for use in updating the offset and a magnetic data set distributed in a principal axis direction with smaller dispersion is a less significant statistical population for use in updating the offset.

The functions of each of the plurality of parts provided in the invention are implemented by hardware resources whose functions are specified by the configuration itself, or hardware resources whose functions are specified by a program, or a combination thereof. The functions of each of the plurality of parts are not limited to those implemented by physically independent hardware resources. The invention can be specified not only by a device but also by a program, a recording medium on which the program is recorded, and a method. The operations of the method described in the claims are not necessarily performed in the order as described in the claims and may be performed in any other order or at the same time, provided there is no technical impediment.

### BRIEF DESCRIPTION OF THE DRAWINGS

FIG. 1 is a schematic diagram of an embodiment of the invention;
FIG. 2 is a schematic diagram of an embodiment of the invention;
FIG. 3 is a block diagram of an embodiment of the invention;
FIG. 4 is a block diagram of an embodiment of the invention;
FIG. 5 is a flow chart of a first embodiment of the invention;
FIG. 6 is a schematic diagram of the first embodiment of the invention;
FIG. 7 is a schematic diagram of the first embodiment of the invention; and
FIG. 8 is a flow chart of a second embodiment of the invention.

### DETAILED DESCRIPTION OF THE INVENTION

Embodiments of the invention will be described in the following order.
A. First Embodiment
   [1. General Description]
   1-1. Hardware Structure
   1-2. Software Structure
   [2. Procedure]
   2-1. Overall Flow
   2-2. Buffer Update
   2-3. Estimation of Distribution
   2-4. Derivation of New Offset through Mathematical Programming Problem
   2-5. Derivation of New Offset when the Distribution is Three-Dimensional
   2-6. Derivation of New Offset when the Distribution is Two-Dimensional
   2-7. Derivation of New Offset when the Distribution is Substantially One-Dimensional
   2-8. Summary
B. Second Embodiment
   - Overview
   - Estimation of Distribution
   - Derivation of New Offset
C. Other Embodiments

### [General Description]

### 1-1. Hardware Structure

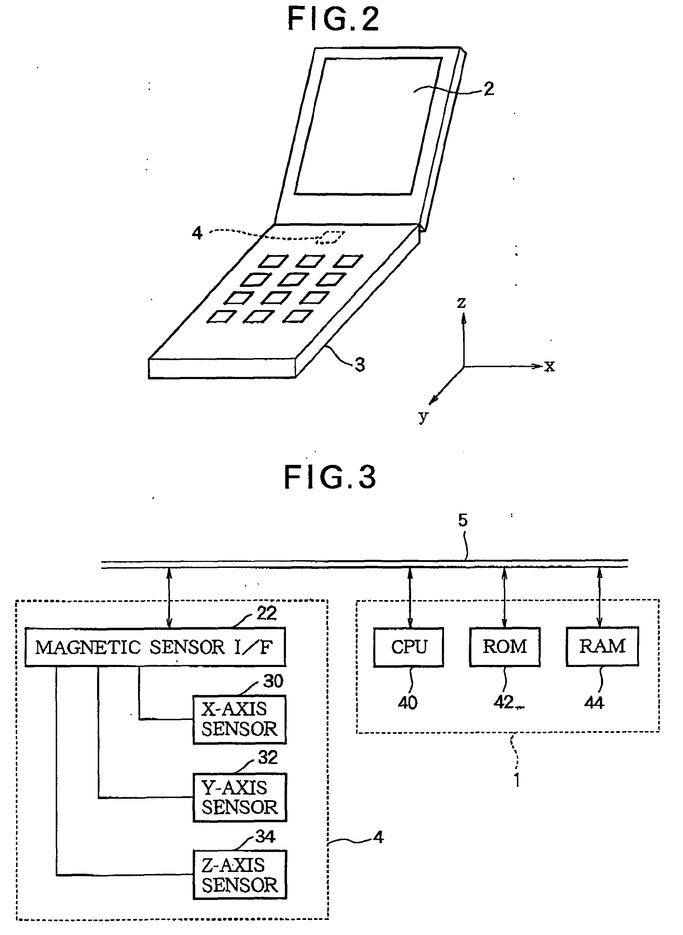

FIG. 2 is a schematic diagram of an external appearance of a mobile phone 3 that is an example of a moving body to which the invention is applied. The mobile phone 3 includes a 3-dimensional (3D) magnetic sensor 4. The 3D magnetic sensor 4 detects the direction and intensity of the Earth's magnetic field by detecting respective intensities of the magnetic field in three orthogonal directions (x, y, z). A display 2 of the mobile phone 3 displays a variety of character or image information. For example, the display 2 displays a map and an arrow or characters representing the orientation (or azimuth).

FIG. 3 is a block diagram of a magnetic measurement device which includes a 3D magnetic sensor 4 and a magnetic data processing device 1. The 3D magnetic sensor 4 includes x, y, and z-axis sensors 30, 32, and 34 that detect x, y, and z direction components of a magnetic field vector due to the Earth's magnetism. Each of the x, y, and z-axis sensors 30, 32, and 34 includes a magnetic resistance element, a Hall sensor, or the like, which may be any type of one-dimensional magnetic sensor provided that it has directivity. The x, y, and z-axis sensors 30, 32, and 34 are fixed so that their sensitive directions are perpendicular to each other. outputs of the x, y, and z-axis sensors 30, 32, and 34 are time-divided and input to a magnetic sensor interface (I/F) 22. The magnetic sensor interface 22 analog-to-digital converts the inputs from the x, y, and z-axis sensors 30, 32, and 34 after amplifying the inputs. Digital magnetic data output from the magnetic sensor interface 22 is input to the magnetic data processing device 1 through a bus 5.

The magnetic data processing device 1 is a computer including a CPU 40, a ROM 42, and a RAM 44. The CPU 40 controls overall operation of, for example, the mobile phone 3. The ROM 42 is a nonvolatile storage medium which stores a magnetic data processing program and a variety of programs (for example, a navigation program) used to implement functions of the moving body, which are executed by the CPU 40. The RAM 44 is a volatile storage medium which temporarily stores data to be processed by the CPU 40. The magnetic data processing device 1 and the 3D magnetic sensor 4 may be constructed as a one-chip magnetic measurement device.

### 1-2. Software Structure

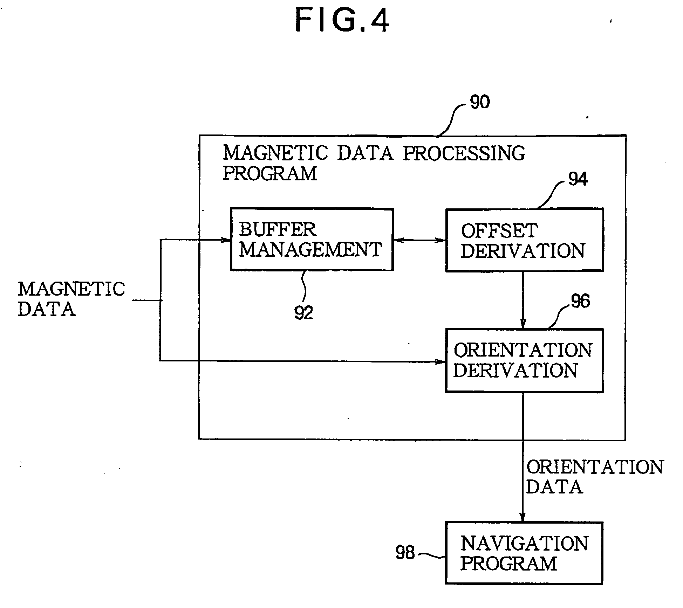

FIG. 4 is a block diagram of a magnetic data processing program 90. The magnetic data processing program 90 is stored in the ROM 42 to provide orientation data to a navigation program 98. The orientation data is 2D vector data representing the orientation of the Earth's magnetic field. As 3D vector data for attitude detection of, for example, a moving body, the orientation data may be provided to other applications. The magnetic data processing program 90 is constructed as a group of modules such as a buffer management module 92, an offset derivation module 94, and an orientation derivation module 96.

The buffer management module 92 is a program part that receives a plurality of magnetic data (or magnetic data samples) sequentially output from the magnetic sensor 4 and stores the received magnetic data in a buffer in order to use the magnetic data in offset update. The buffer management module 92 allows the CPU 40, the RAM 44, and the ROM 42 to function as input part and storage part. This buffer may be embodied not only in hardware but also in software. A plurality of magnetic data stored in this buffer will hereinafter be referred to as a "statistical population".

The offset derivation module 94 is a program part that derives a new offset based on a statistical population held by the buffer management module 92 and an old offset held by the offset derivation module 94, and updates the old offset with the new offset. The offset derivation module 94 allows the CPU 40, the RAM 44, and the ROM 42 to function as offset derivation part. Since updating the old offset with the new offset causes the new offset to become an old offset, the "old offset" will be referred to simply as an "offset" in contexts in which it causes no misunderstanding. Actually, an offset used for orientation data correction is set in one variable and the new offset is derived as a different variable from that variable. When the new offset is derived, it is set in the variable used for orientation data correction. Therefore, the variable used for orientation data correction is that in which the old offset is stored.

The orientation derivation module 96 is a program part that corrects the magnetic data sequentially output from the magnetic sensor using the offset held by the offset derivation module 94 and creates orientation data based on the corrected magnetic data. The orientation derivation module 96 allows the CPU 40, the RAM 44, and the ROM 42 to function as orientation derivation part. Specifically, the orientation derivation module 96 outputs, as orientation data, all or two of the 3 components obtained by subtracting the components of the offset from the components of the magnetic data which is 3D vector data.

The navigation program 98 is a known program that searches for a route to a destination and displays the route on a map. To enhance readability of the map, the map is displayed such that the orientation thereof matches the real-world orientation. Accordingly, for example, when the mobile phone 3 is rotated, the map displayed on the display 2 is rotated relative to the display 2 such that the map is not rotated relative to the earth. The orientation data is used in this map display processing. Of course, the orientation data may be used only to display north, south, east and west by characters or arrows.

### [2. Procedure]

### 2-1. Overall Flow

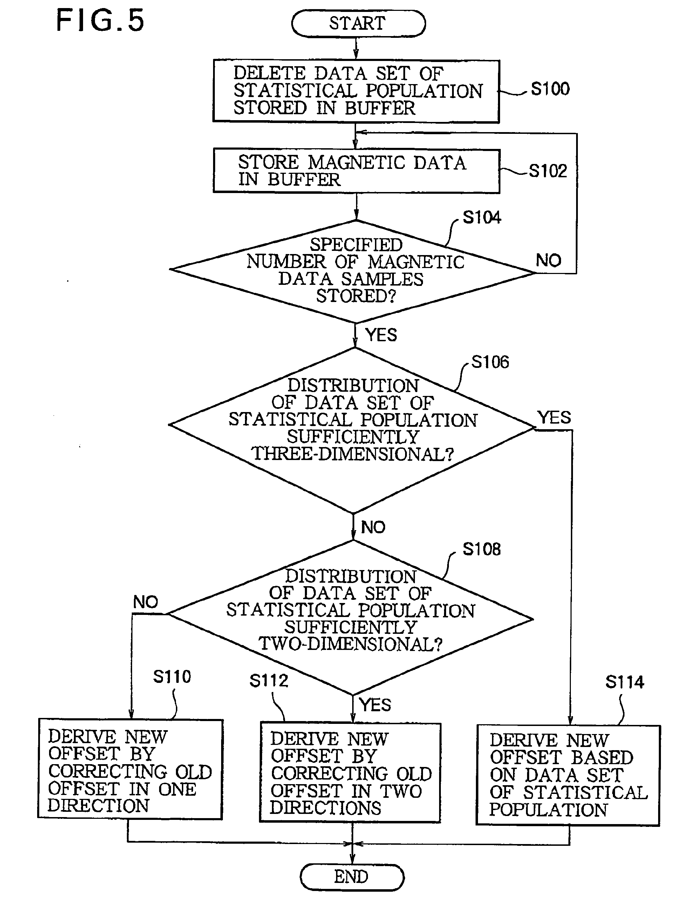

FIG. 5 is a flow chart illustrating a new offset derivation procedure. The CPU 40 performs the procedure of FIG. 5 by executing the offset derivation module 94 when an offset update request has been made.

### 2-2. Buffer Update

At step S100, all magnetic data stored in the buffer, in which a plurality of magnetic data (statistical population) used for deriving a new offset is stored, is deleted. That is, in this process, a plurality of magnetic data (statistical population) used for deriving the old offset is deleted.
At step S102, magnetic data used for deriving a new offset is input and stored in the buffer. When a plurality of magnetic data are sequentially input from the magnetic sensor 4 with almost no change in the attitude of the mobile phone 3, the distance between two sequentially input magnetic data (elements) is small. Storing a plurality of near magnetic data (elements) in a buffer with a limited capacity wastes memory resources and causes unnecessary buffer update processes. In addition, if a new offset is derived based on a set of near magnetic data, there is a possibility that an inaccurate new offset is derived based on an unevenly distributed statistical population. Whether or not it is necessary to update the buffer may be determined in the following manner. For example, if the distance between the last input magnetic data and magnetic data stored in the buffer immediately before the last input magnetic data is less than a given threshold, it is determined that it is unnecessary to update the buffer and the last input magnetic data is discarded without being stored in the buffer.

At step S104, it is determined whether or not a specified number of magnetic data sufficient to derive an accurate new offset has been stored in the buffer. That is, the number of elements of the statistical population is predetermined. Setting a small number of elements of the statistical population improves response to the offset update request. The processes of steps S102 and S104 are repeated until the specified number of magnetic data is stored in the buffer.

### 2-3. Estimation of Distribution

Once the specified number of samples of magnetic data is stored in the buffer, the distribution of the statistical population is estimated (steps S106 and S108). The distribution is estimated based on principal values of the distribution. As the statistical population, a magnetic data set is expressed by the following Equation (1). Here, a true value pᵢ and an error Δpᵢ are introduced and the error Δpᵢ is approximated by a random variable vᵢ following a probability distribution µ. That is, qᵢ (i = 1, 2, ...) is expressed as follows. ${q}_{i} = {p}_{i} + {v}_{i} = \left({q}_{ix}⁢{q}_{iy}⁢{q}_{iz}\right) \left(1=1,2,…\right)$
The principal values of the distribution are eigenvalue of a symmetric matrix A' defined by Equations (2), (3), (4), and (5) using vectors starting from a center (average) of the statistical population and ending with the respective magnetic data samples.
Here, it is assumed that the probability distribution µ is a normal distribution whose average is 0 and whose variance - covariance matrix is expressed by "V". $Aʹ = A - \left(n-1\right) ⁢ V$ $A = {X}^{T} ⁢ X$ $X = \left[\begin{matrix}{\left({q}_{1}-\overline{q}\right)}^{T} \\ ⋮ \\ {\left({q}_{n}-\overline{q}\right)}^{T}\end{matrix}\right]$ $\overline{q} = \frac{1}{n} {\sum }_{i = 1}^{n} {q}_{i}$
The matrix A may also be rewritten as the following Equation (6). $A = {\sum }_{i = 1}^{N} \left({q}_{i}-\overline{q}\right) ⁢ {\left({q}_{i}-\overline{q}\right)}^{T}$

Let λ₁, λ₂, and λ₃ be the eigenvalue of the matrix A' in descending order. Let u₁, u₂, and u₃ be mutually orthogonal eigenvectors that correspond to λ₁, λ₂, and λ₃ and have been normalized to 1. When two or more eigenvalues of the matrix A' are zero, i.e., when the rank of the matrix A' is one or less, there is no need to consider it since the number of elements of the statistical population is one or the distribution is a perfectly straight line.
The distribution of the statistical population is estimated based both on the minimum eigenvalue λ₃ and on the intermediate eigenvalue λ₂.

At step S106, it is determined whether or not the distribution of the statistical population is sufficiently three-dimensional, Specifically, this determination is affirmative when the following condition (7) is satisfied, and otherwise the determination is negative when it is not satisfied. ${λ}_{3} > {t}_{1} and {λ}_{2} > {t}_{2}$
Here, "t₁" and "t₂" are predetermined constants. How the values t₁ and t₂ are set is a design option and the values t₁ and t₂ can optionally be set based on how the derivation characteristics of the offset is determined. When the condition (7) is satisfied, the statistical population is distributed isotropically from the center of the statistical population. The isotropic distribution of the statistical population about the center indicates that the statistical population is distributed evenly or uniformly near a specific sphere.

At step S108, it is determined whether or not the distribution of the statistical population is sufficiently two-dimensional. Specifically, the determination is affirmative when the following condition (8) is satisfied, and otherwise the determination is negative when it is not satisfied. ${λ}_{3} \leq {t}_{1} and {λ}_{2} > {t}_{2}$
When the condition (8) is satisfied, the statistical population is distributed isotropically from the center of then statistical population in a range restricted near a specific plane. The isotropic distribution of the statistical population about the center in a range restricted near a specific plane indicates that the statistical population is unevenly distributed near the circumference of a sectional circle of a specific sphere.

When the determination of step S108 is negative, the distribution of the statistical population is substantially one-dimensional (i.e., linear). The substantially linear distribution of the statistical population indicates that the statistical population is unevenly distributed on a short arc of a sectional circle of a specific sphere or on both ends of a diameter of the sectional circle.

### 2-4. Derivation of New Offset through Mathematical Programming Problem

A mathematical programming problem for deriving a new offset will now be described.
When the statistical population includes 4 magnetic data (elements) that are not present on the same plane, a sphere on which the statistical population is distributed is uniquely determined without using a statistical technique. A position vector c = (cₓ, c_{y}, c_{z}) of the center of this sphere is obtained by solving simultaneous Equations (9). Although four equality constraints exist for three variables, the Equations (9) must have a solution since one of the four equality constraints is redundant. $\left[\begin{matrix}{\left({q}_{1}-\overline{q}\right)}^{T} \\ ⋮ \\ {\left({q}_{4}-\overline{q}\right)}^{T}\end{matrix}\right] ⁢ c = \frac{1}{2} ⁢ \left[\begin{matrix}{{q}_{1}}^{T} ⁢ {q}_{1} - R \\ ⋮ \\ {{q}_{4}}^{T} ⁢ {q}_{4} - R\end{matrix}\right]$
where $R = \frac{1}{n} {\sum }_{i = 1}^{n} {{q}_{i}}^{T} ⁢ {q}_{i}$

When the number of elements of the statistical population is 5 or more, "j" is defined by the following Equation (11). $j = \frac{1}{2} ⁢ \left[\begin{matrix}{{q}_{1}}^{T} ⁢ {q}_{1} - R \\ ⋮ \\ {{q}_{n}}^{T} ⁢ {q}_{n} - R\end{matrix}\right]$
Here, if simultaneous linear Equations (12) for "c" have a solution, the solution is the center of a sphere on which the statistical population is distributed. $Xc = j$

However, if a measurement error of the 3D magnetic sensor 4 is considered, it is practically impossible for Equations (12) to have a solution. Thus, "c" which minimizes a function fᵥ(c) of the following Equation (13), which is an index of variance of dᵢ, can be considered the most probable new offset. ${f}_{v} \left(c\right) = \frac{1}{4} {\sum }_{i = 1}^{n} {\left({d}_{i}-\overline{d}\right)}^{2}$
Here, dᵢ and *d̅̅̅* are expressed as follows. ${d}_{i} = {‖ \left({q}_{i}-{v}_{i}\right) - c ‖}^{2}$ $\overline{d} = \frac{1}{n} {\sum }_{i = 1}^{n} {d}_{i}$
The function fᵥ(c) can be rewritten as the following Equation (21) when q̅ , *v̅* , Xᵥ, Rᵥ, and jᵥ are defined as follows. $\overline{q} = \frac{1}{n} {\sum }_{i = 1}^{n} {q}_{i}$ $\overline{v} = \frac{1}{n} {\sum }_{i = 1}^{n} {v}_{i}$ ${X}_{v} = \left[\begin{matrix}{\left\{\begin{matrix}\left({q}_{1}-{v}_{1}\right) - \left(\overline{q}-\overline{v}\right)\end{matrix}\right\}}^{T} \\ ⋮ \\ {\left\{\begin{matrix}\left({q}_{n}-{v}_{n}\right) - \left(\overline{q}-\overline{v}\right)\end{matrix}\right\}}^{T}\end{matrix}\right]$ ${R}_{v} = \frac{1}{n} {\sum }_{i = 1}^{n} {\left({q}_{i}-{v}_{i}\right)}^{T} ⁢ \left({q}_{i}-{v}_{i}\right)$ ${j}_{v} = \frac{1}{2} ⁢ \left[\begin{matrix}{\left({q}_{1}-{v}_{1}\right)}^{T} ⁢ \left({q}_{1}-{v}_{1}\right) - {R}_{v} \\ ⋮ \\ {\left({q}_{n}-{v}_{n}\right)}^{T} ⁢ \left({q}_{n}-{v}_{n}\right) - {R}_{v}\end{matrix}\right]$ ${f}_{v} \left(c\right) = {c}^{T} \left({X}_{v}^{T}⁢{X}_{v}\right) ⁢ c - 2 ⁢ {\left({X}_{v}^{T}⁢{j}_{v}\right)}^{T} ⁢ c + {j}_{v}^{T} ⁢ {j}_{v}$

When each term of the function (21) including a time-independent random variable, vᵢ is substituted with an expected value corresponding to the probability distribution µ while assuming that the probability distribution µ is a normal distribution whose average is 0 and whose variance-covariance matrix is expressed by "V", a stochastic model expressed Equation (21) is replaced with a deterministic model expressed by the following Equation (22). Here, A' = A - (n-1)V as described above. $f \left(c\right) = {c}^{T} ⁢ Aʹc - 2 ⁢ {\left({X}^{T}⁢j-\left(n-1\right)⁢V⁢\overline{q}\right)}^{T} ⁢ c + {j}^{T} ⁢ j$
Namely, the Equation (22) is derived by obtaining an expected value of the Equation (21) following the probability distribution µ, and by replacing each term containing the random variable v₁ which is time-independent among terms of the expected value of the Equation (21) with an expected value corresponding to the probability distribution µ.

When the symbol "E[ ]" denotes an expected value, the above noted transformation of the Equation (21) into the Equation (22) is generally expressed by f(c) = E[fᵥ(c) ]. Specifically, substitutions of the following Equations (23), (24), and (25) are applied to the procedure for replacing Equation (21) with Equation (22) since the probability distribution µ is a normal distribution whose average is 0 and whose variance-covariance matrix is expressed by "V" and is also time independent. $E \left[{v}_{i}\right] = 0$ $E \left[{v}_{i}⁢{v}_{i}^{T}\right] = V$ $E \left[{v}_{i}⁢{v}_{j}^{T}\right] = 0 \left(i\neq j\right)$

### 2-5. Derivation of New Offset when the Distribution is Three-Dimensional

When the distribution is three-dimensional, a new offset is derived without restricting directions in which the old offset is corrected (step S114). When the distribution is three-dimensional, i.e., if the statistical population is distributed in all directions to a certain extent as seen from the center of the statistical population, the statistical population is sufficiently reliable in all directions. Accordingly, in this case, to derive the new offset, it is unnecessary to use the old offset and thus the new offset can be derived based on the statistical population without using the old offset. An algorithm for deriving a new offset based on the statistical population without using the old offset may be an algorithm that uses one of a variety of statistical techniques that have been suggested and may also be an algorithm that uses no statistical technique as described in Japanese Patent Application Publication Nos. 2005-337412 and 2006-44289 filed by the present applicant.

In this embodiment, a new offset is derived using a probabilistic method. That is, at step S114, the new offset "c" is derived as a solution to the mathematical programming problem for minimizing the objective function of Equation (22) Without any constraint condition.
When A' is positive definite, "c" which minimizes the objective function f(c) expressed by Equation (22) is expressed as follows. $c = {Aʹ}^{- 1} ⁢ \left({X}^{T}⁢j-\left(n-1\right)⁢V⁢\overline{q}\right)$
When A' is not positive definite, "c" which minimizes the objective function f(c) expressed by Equation (22) does not exist or is not uniquely determined.

When R' and j' are defined as in the following Equations (27) and (28), "c" which minimizes the objective function f(c) expressed by Equation (22) is expressed by the following Equation (29). $Rʹ = \frac{1}{n} {\sum }_{i = 1}^{n} {\left({q}_{i}-\overline{q}\right)}^{T} ⁢ \left({q}_{i}-\overline{q}\right)$ $jʹ = \frac{1}{2} ⁢ \left[\begin{matrix}{\left({q}_{1}-\overline{q}\right)}^{T} ⁢ \left({q}_{1}-\overline{q}\right) - Rʹ \\ ⋮ \\ {\left({q}_{n}-\overline{q}\right)}^{T} ⁢ \left({q}_{n}-\overline{q}\right) - Rʹ\end{matrix}\right]$ $c = {Aʹ}^{- 1} ⁢ {X}^{T} ⁢ jʹ + \overline{q}$
That is, when the distribution of the statistical population is sufficiently three-dimensional, "c" which satisfies one of the Equations (26) and (29) may be derived as the new offset. Which one of the Equations (26) and (29) is used to derive the new offset is a design option.

### 2-6. Derivation of New Offset when the Distribution is Two-Dimensional

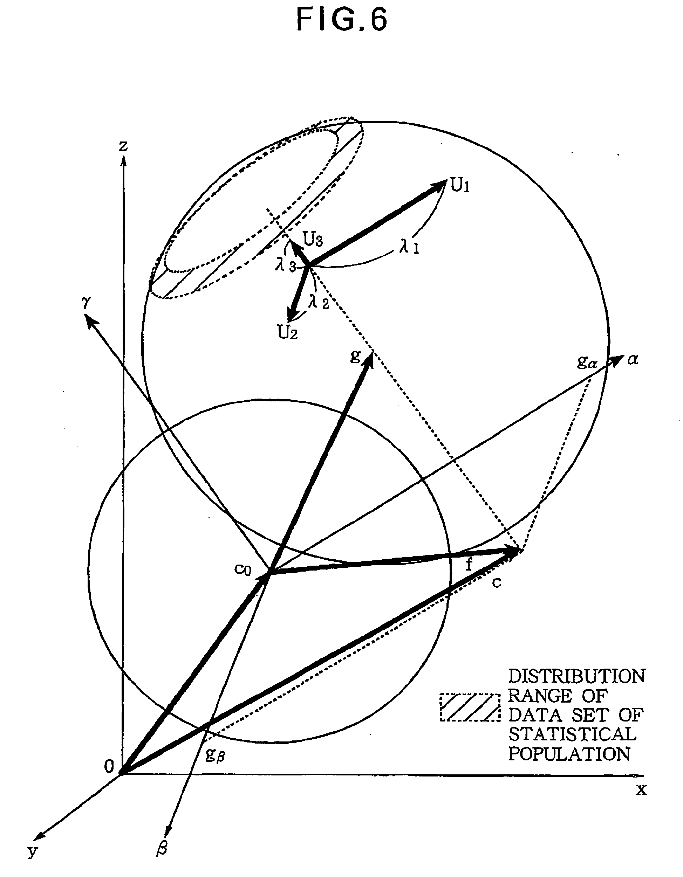

As shown in FIG. 6, when the distribution of the statistical population is two-dimensional (i.e., planar), a new offset is derived by restricting directions in which the old offset is corrected to two orthogonal directions (step S112). When the statistical population is distributed near a specific plane and therefore the population is scattered when viewed from a direction normal to the plane, the distribution of the statistical population in a direction parallel to the plane is sufficiently reliable while the distribution of the statistical population in the direction normal to the plane is unreliable. In this case, the old offset is not corrected in the direction normal to the plane, thereby preventing the offset from being updated based on unreliable information.

When the statistical population is distributed near a specific plane and the population is scattered when viewed from a direction normal to the plane, the direction normal to the plane is coincident with the direction of an eigenvector u₃ corresponding to the minimum eigenvalue λ₃ and orthogonal directions parallel to the plane are coincident with the directions of eigenvectors u₁ and u₂ corresponding respectively to the maximum eigenvalue λ₁ and the intermediate eigenvalue λ₂. Accordingly, in order to derive a new offset without correcting the old offset in the direction normal to the plane, a new offset c which minimizes the objective function of Equation (22) is found under a constraint condition expressed by the following Equation (30). $c = {c}_{0} + {β}_{1} ⁢ {u}_{1} + {β}_{2} ⁢ {u}_{2} \left({β}_{1}, {β}_{2}:real numbers\right)$
Equation (30) is equivalent to the following Equation (31). ${{u}_{3}}^{T} ⁢ \left(c-{c}_{0}\right) = 0$

The equation for solving the mathematical programming problem of Equation (22) under the constraint condition of Equation (30) can be modified to its equivalent simultaneous equations using the method of Lagrange multipliers. When an unknown constant multiplier p is introduced and "x" is defined by the following Equation (32), simultaneous linear Equations (33) of "x" are identical to the above simultaneous equations. $x = \left[\begin{matrix}c \\ ρ\end{matrix}\right]$ ${B}_{4} ⁢ x = {b}_{4} ,$
where ${B}_{4} = \left[\begin{matrix}Aʹ & {u}_{3} \\ {{u}_{3}}^{T} & 0\end{matrix}\right]$ ${b}_{4} = \left[\begin{matrix}{X}^{T} ⁢ j - \left(n-1\right) ⁢ V ⁢ \overline{q} \\ {{u}_{3}}^{T} ⁢ {c}_{0}\end{matrix}\right]$

That is, if the distribution of the statistical population is two-dimensional, the new offset may be derived at step S112 by solving the simultaneous linear Equations (33). The solution "x" must be uniquely determined since the rank of the matrix B₄ must be 4. The new offset c may also be derived by solving Equation (38) using a solution to the following simultaneous Equations (37) for c' and an unknown constant multiplier p', where *b*'₄ is given as follows. ${b}_{4}^{ʹ} = \left[\begin{matrix}{X}^{T} ⁢ jʹ \\ {{u}_{3}}^{T} ⁢ {c}_{0}\end{matrix}\right]$ ${B}_{4} \left[\begin{matrix}cʹ \\ ρʹ\end{matrix}\right] = {b}_{4}^{ʹ}$ $c = cʹ + \overline{q}$

### 2-7. Derivation of New Offset when the Distribution is Substantially One-Dimensional

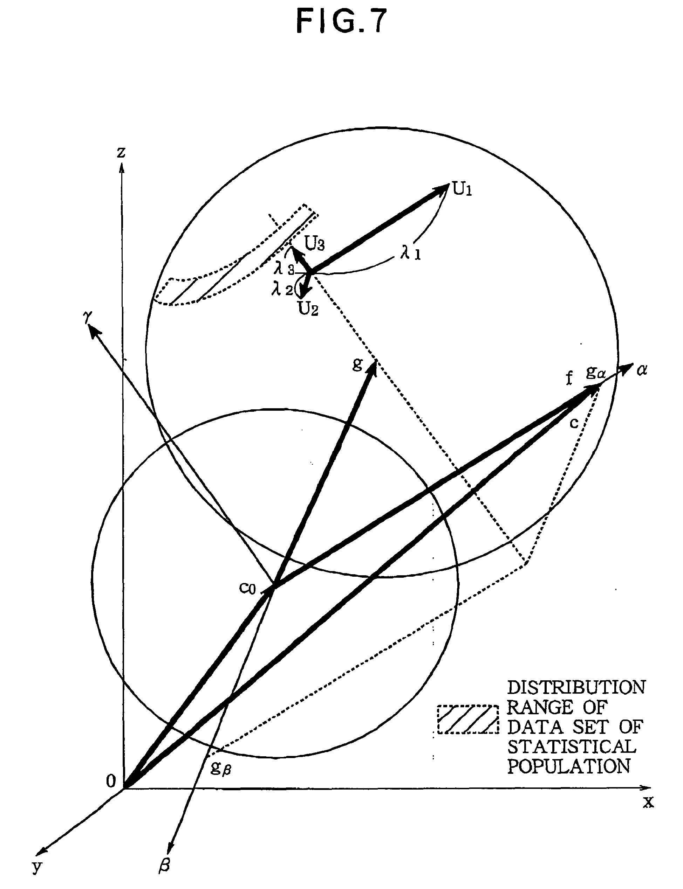

As shown in FIG. 7, when the distribution of the statistical population is substantially one-dimensional (i.e., linear), a new offset is derived by restricting directions in which the old offset is corrected to one principle direction of the distribution (step S110). When the statistical population is distributed near a specific line and the distribution is discrete in the direction of the line, the distribution of the statistical population in the direction of the straight line is sufficiently reliable while the distribution of the statistical population in other directions is unreliable. In this case, the old offset is not corrected in directions other than the direction of the line, thereby preventing the offset from being updated based on unreliable information.

When the statistical population is distributed near a specific line and the distribution is discrete in the direction of the line, the direction of the line is coincident with the direction of an eigenvector u₁ corresponding to the maximum eigenvalue λ₁ and the other directions are coincident with the directions of eigenvectors u₂ and u₃ corresponding respectively to the intermediate eigenvalue λ₂ and the minimum eigenvalue λ₃. Accordingly, in order to derive a new offset only in the direction of the line, a new offset c which minimizes the objective function of Equation (22) is found under a constraint condition expressed by the following Equation (39). $c = {c}_{0} + {β}_{1} ⁢ {u}_{1}$
Equation (39) is equivalent to simultaneous satisfaction of the following Equations (40) and (41). ${u}_{2}^{T} ⁢ \left(c-{c}_{0}\right) = 0$ ${u}_{3}^{T} ⁢ \left(c-{c}_{0}\right) = 0$

The equation for solving the mathematical programming problem of Equation (22) under the constraint condition of Equation (39) can be modified to its equivalent simultaneous equations using the method of Lagrange multipliers. When unknown constant multipliers p₁ and p₂ are Introduced and "x" is defined by the following Equation (42), simultaneous linear Equations (43) of "x" are identical to the above simultaneous equations. $x = \left[\begin{matrix}c \\ {ρ}_{1} \\ {ρ}_{2}\end{matrix}\right]$ ${B}_{5} ⁢ x = {b}_{5}$
Where ${B}_{5} = \left[\begin{matrix}Aʹ & {u}_{2} & {u}_{3} \\ {{u}_{2}}^{T} & 0 & 0 \\ {{u}_{3}}^{T} & 0 & 0\end{matrix}\right]$ ${b}_{5} = \left[\begin{matrix}{X}^{T} ⁢ j - \left(n-1\right) ⁢ V ⁢ \overline{q} \\ {{u}_{2}}^{T} ⁢ {c}_{0} \\ {{u}_{3}}^{T} ⁢ {c}_{0}\end{matrix}\right]$

That is, if the distribution of the statistical population is substantially one-dimensional, the new offset may be derived at step S110 by solving the simultaneous linear Equations (43). The solution "x" must be uniquely determined since the rank of the matrix B₅ must be 5. Of course, the finally derived value c is also uniquely determined. The new offset c may also be derived by solving Equation (48) using a solution to the following simultaneous Equations (47) for c' and unknown constant multipliers p₁' and p₂' where *b'₅* is given as follows. ${b}_{5}^{ʹ} = \left[\begin{matrix}{X}^{T} ⁢ jʹ \\ {{u}_{2}}^{T} ⁢ {c}_{0} \\ {{u}_{3}}^{T} ⁢ {c}_{0}\end{matrix}\right]$ ${B}_{5} \left[\begin{matrix}cʹ \\ {{ρ}_{1}}^{ʹ} \\ {{ρ}_{2}}^{ʹ}\end{matrix}\right] = {b}_{5}^{ʹ}$ $c = cʹ + \overline{q}$

### 2-8. Summary

The processes of steps S110, S112, and S114 will now be described using spatial concepts with reference to FIGS. 1, 6, and 7. If it is assumed that the statistical population is completely reliable, the new offset c is defined by the following Equation (49) by considering the new offset c as the sum of the old offset c₀ and a position vector g of the center of a sphere, derived from only the statistical population, relative to the old offset c₀. $c = {c}_{0} + g$

The position vector g derived as a solution to the mathematical programming problem for minimizing the objective function of Equation (21) without any constraint condition is a linear combination of fundamental vectors in the same directions as the eigenvectors u₁, u₂, and u₃ of the distribution. Therefore a correction vector "f", which corresponds to a vector corrected from the position vector "g" according to the respective degrees of reliability of the components of the position vector "g", can be obtained by weighting coefficients gₐ, g_{B}, and g_{Y} of the position vector "g" according to the respective degrees of reliability of the statistical population in the corresponding principal axis directions (see FIG. 1).

In the process of step S112 which is performed when the distribution of the (statistical population is two-dimensional as shown in FIG. 6, the following constraint condition is imposed when deriving a new offset based on the old offset c₀ and the statistical population. The constraint condition is that the new offset c be obtained as the sum of the old offset c₀ and a correction vector "f" that is obtained by weighting both a coefficient gₐ of the position vector "g" in a principal axis direction of the distribution corresponding to the maximum principal value of the distribution (i.e., corresponding to the maximum eigenvalue λ₁) and a coefficient g_{B} in a principal axis direction of the distribution corresponding to the intermediate principal value of the distribution (i.e., corresponding to the intermediate eigenvalue λ₂) by a weighting factor of "1" of the position vector "g" and weighting a coefficient g_{γ} in a principal axis direction of the distribution corresponding to the minimum principal value of the distribution (i.e., corresponding to the minimum eigenvalue λ₃) by a weighting factor of "0" of the position vector "g".

In the process of step S110 which is performed when the distribution of the statistical population is substantially one-dimensional as shown in FIG. 7, the following constraint condition is imposed when deriving a new offset based on the old offset c₀ and the statistical population. The constraint condition is that the new offset c be obtained as the sum of the old offset c₀ and a correction vector "f" that is obtained by weighting a coefficient gₐ of the position vector "g" in a principal axis direction (or a principle direction) of the distribution corresponding to the maximum principal value of the distribution (i.e., corresponding to the maximum eigenvalue λ₁) by a weighting factor of "1" of the position vector "g" and weighting both a coefficient g_{B} in a principal axis direction of the distribution corresponding to the intermediate principal value of the distribution (i.e., corresponding to the intermediate eigenvalue λ₂) and a coefficient g_{γ} in a principal axis direction of the distribution corresponding to the minimum principal value of the distribution (i.e., corresponding to the minimum eigenvalue λ₃) by a weighting factor of "0" of the position vector "g" .

In the process of step S114 which is performed when the distribution of the statistical population is three-dimensional, no specific constraint condition is imposed. That is, at step S114, the new offset c is obtained as the sum of the old offset c₀ and the position vector "g" that is obtained as a solution to the mathematical programming problem for minimizing the objective function of Equation (22) without any constraint condition. As a result, the new offset is derived without using the old offset c₀.

### B. Second Embodiment

### Overview

In the first embodiment, the distribution of the statistical population is estimated discretely and, when the distribution is two-dimensional, the new offset "c" is derived by setting the component of the correction vector "f" in the principal axis direction, in which the principal value is the minimum value, to zero and, when the distribution is one-dimensional, the new offset "c" is derived by setting the components of the correction vector "f" in the two principal axis directions, in which the principal values are the intermediate and minimum values, to zero. In the second embodiment, a description will be given of a simple, highly accurate algorithm that can eliminate the need to perform different processes according to estimations of the distribution as in the first embodiment and can also derive a more probable new offset by efficiently using the statistical population.

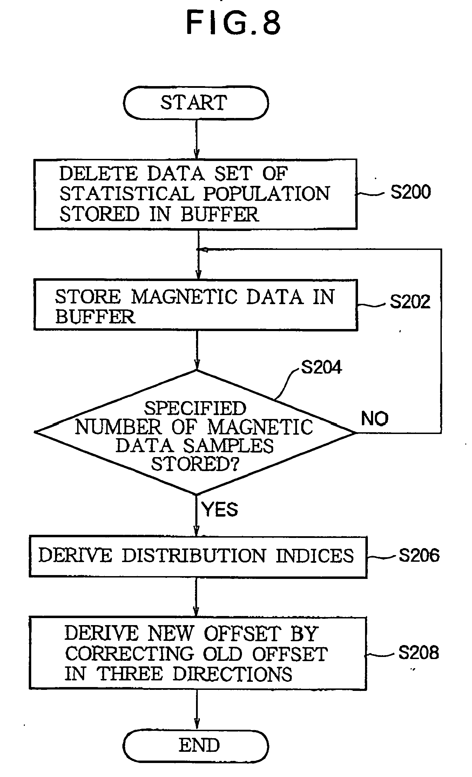

FIG. 8 is a flow chart illustrating a new offset derivation process. In the same manner as in the first embodiment, the CPU 40 performs the procedure of FIG. 8 by executing the offset derivation module 94 when an offset update request has been made. The process of step S200 is the same as that of the process of step S100 described above in the first embodiment. The process of step S202 is the same as that of the process of step S102 described above in the first embodiment. The process of step S204 is the same as that of the process of step S104 described above in the first embodiment.

### Estimation of Distribution

At step S206, distribution indices of the statistical population are derived. For example, the distribution of the statistical population is estimated by deriving distribution indices m₂ and m₃ defined by the following equations (50) and (51). ${m}_{2} = { \begin{matrix}{\left(\frac{1}{{λ}_{2} + 1}\right)}^{{k}_{2}} & \left({λ}_{2}\geq 0\right) \\ 1 & \left({λ}_{2}<0\right)\end{matrix}$ ${m}_{3} = { \begin{matrix}{\left(\frac{1}{{λ}_{3} + 1}\right)}^{{k}_{3}} & \left({λ}_{3}\geq 0\right) \\ 1 & \left({λ}_{3}<0\right)\end{matrix}$

Here, "k₂" and "k₃" are predetermined positive constants. The values of k₂ and k₃ determine the association between principal values and the degrees of reliability of corresponding principal axis directions of the statistical population. Here, distribution indices "m₂" and "m₃" satisfy the following conditions. The distribution indices "m₂" and "m₃" may be determined to have any value as long as the following conditions are satisfied.
m₂ = 1 when λ₂<0
m₃ = 1 when λ₃< 0
The range of m₂ and m₃ is [0, 1] or a subset thereof.
m₂ is a weakly decreasing function of λ₂ .
m₃ is a weakly decreasing function of λ₃.

When the coefficients of the components of the position vector g in the principal axis directions of the distribution are denoted by g_{a,} g_{B}, and g_{Y} in decreasing order of the corresponding principal values and the coefficients of the components of the position vector f in the principal axis directions of the distribution are denoted by fₐ, f_{B}, and f_{γ} in decreasing order of the corresponding principal values, the relationships between the position vector g, the correction vector f, and m₂ and m₃ are expressed by the following equations (52), (53), and (54). $\frac{{f}_{α}}{{g}_{α}} = 1$ $\frac{{f}_{β}}{{g}_{β}} = \frac{\left(\frac{{λ}_{2}}{{λ}_{1}}\right) ⁢ {m}_{2} - \left(\frac{{λ}_{2}}{{λ}_{1}}\right)}{\left(\frac{{λ}_{2}}{{λ}_{1}}\right) ⁢ {m}_{2} - \left(\frac{{λ}_{2}}{{λ}_{1}}\right) - {m}_{2}^{2}}$ $\frac{{f}_{γ}}{{g}_{γ}} = \frac{\left(\frac{{λ}_{3}}{{λ}_{1}}\right) ⁢ {m}_{3} - \left(\frac{{λ}_{3}}{{λ}_{1}}\right)}{\left(\frac{{λ}_{3}}{{λ}_{1}}\right) ⁢ {m}_{3} - \left(\frac{{λ}_{3}}{{λ}_{1}}\right) - {m}_{3}^{2}}$

### ● Derivation of New Offset

When it is difficult to derive a solution to the mathematical programming problem under a specific constraint condition, a relaxation problem for solving the mathematical programming problem by relaxing the constraint condition may be introduced. By applying this relaxation problem, this embodiment realizes a process for deriving a new offset c as the sum of the old offset c₀ and a correction vector f that is obtained by weighting the coefficients gₐ, g_{B}, and g_{γ} of the position vector g (see FIG. 1) described above by weighting factors corresponding to the principal values of the distribution of the statistical population. The following are details of this process.

Unknown constant multipliers ρ₁ and ρ₂ are defined as variables required for calculations during the process and c, ρ₁, and ρ₂ are grouped into a vector "x" that is defined by the following equation (55). $x = \left[\begin{matrix}c \\ {ρ}_{1} \\ {ρ}_{2}\end{matrix}\right]$

In addition, a matrix "B" is defined by Equations (56) and a vector "b" is defined by Equation (57). $B = \left[\begin{matrix}Aʹ & {m}_{2} ⁢ {u}_{2} & {m}_{3} ⁢ {u}_{3} \\ {m}_{2} ⁢ {{u}_{2}}^{T} & \frac{1}{{λ}_{1}} ⁢ \left({m}_{2}-1\right) & 0 \\ {m}_{3} ⁢ {u}_{3}^{T} & 0 & \frac{1}{{λ}_{1}} ⁢ \left({m}_{3}-1\right)\end{matrix}\right]$ $b = \left[\begin{matrix}{X}^{T} ⁢ j - \left(n-1\right) ⁢ V ⁢ \overline{q} \\ {m}_{2} ⁢ {{u}_{2}}^{T} ⁢ {c}_{0} \\ {m}_{3} ⁢ {{u}_{3}}^{T} ⁢ {c}_{0}\end{matrix}\right]$

The process for deriving a new offset at step S208 is to find a solution to the following simultaneous equations (58). The vector x is uniquely determined since the matrix B must be nonsingular. $Bx = b$
The new offset c may also be derived by solving Equation (61) using a solution to the following simultaneous Equations (60) for c' and unknown constant multipliers ρ'₁ and ρ'₂ where b' is given as the following Equation (59). $bʹ = \left[\begin{matrix}{X}^{T} ⁢ jʹ \\ {m}_{2} ⁢ {{u}_{2}}^{T} ⁢ {c}_{0} \\ {m}_{3} ⁢ {{u}_{3}}^{T} ⁢ {c}_{0}\end{matrix}\right]$ $B \left[\begin{matrix}cʹ \\ {ρ}_{1}^{ʹ} \\ {ρ}_{2}^{ʹ}\end{matrix}\right] = {b}^{ʹ}$ $c = cʹ + \overline{q}$
Finding a solution to the simultaneous equations (58) is equivalent to solving the mathematical programming problem for minimizing the objective function of Equation (22) under a constraint condition that a new offset be obtained as the sum of the old offset c₀ and a correction vector f whose components are values obtained by weighting the coefficients of the position vector g in the principal axis directions of the distribution corresponding to the principal values by factors fₐ/gₐ, f_{B}/g_{B}, and f_{γ}/g_{γ} corresponding to the principal values of the distribution of the statistical population.

In the second embodiment, it is easy to develop or improve the offset derivation module 94 and the data size of the offset derivation module 94 is also decreased since there is no need to branch the new offset derivation process according to the distribution of the statistical population as described above. In addition, the second embodiment allows the offset derivation module 94 to more efficiently use the statistical population and also allows the orientation derivation module to correct magnetic data using the most probable offset since the old offset can be corrected in the principal axis directions of the distribution by distances corresponding to the principal values of the statistical population unless one or more of the principal values is zero or negative.

### C. Other Embodiments

The invention is not limited to the above embodiments and various embodiments are possible without departing from the spirit of the invention. For example, the invention can also be applied to a magnetic sensor that is mounted on a PDA or a magnetic sensor that is mounted on a vehicle. Of course, the invention is applicable not only to a 3D magnetic sensor but also to a 2D magnetic sensor.
In addition, the probability distribution µ, which allows the objective function in the probabilistic programming problem which is a stochastic model to be replaced with the objective function which is a deterministic model using the expected value, is not limited to the normal distribution and may also be a binomial distribution, a uniform distribution, or a Poisson distribution. A term, including an error which is a random variable, in the objective function may be substituted with an expected value corresponding to a probability distribution which best matches the distribution of magnetic data errors among such probability distributions.
Alternatively, even if the actual probability distribution µ is not the normal distribution, the probability distribution µ may be treated as the normal distribution, and the offset may be derived using the expected value corresponding to the normal distribution.
In addition, in the invention, the offset may be derived according to any probabilistic method, provided that the offset is derived using an expected value corresponding to a probability distribution assuming that an error Δpᵢ included in magnetic data is a random variable v₁ following the probability distribution µ. For example, the invention can be practiced by introducing an expected value of an error in a probabilistic method described in publications such as International Patent Publication No. 2006-009247 and Japanese Patent Application Publication Nos. 2007-225325, 2007-225329, and 2007-225332.

## Claims

1. A magnetic data processing device for processing magnetic data to determine an offset thereof, comprising:
an input part that sequentially receives magnetic data q₁ output from a magnetic sensor;
a storage part that sequentially stores the magnetic data received through the input part; and
an offset derivation part that derives an offset according to a probabilistic method using a plurality of the magnetic data stored in the storage part as a statistical population,
wherein the offset derivation part assumes that an error Δp₁ contained in each of the magnetic data q₁ is a random variable Vᵢ following a probability distribution µ, and uses an expected value corresponding to the probability distribution µ for deriving the offset.

2. The magnetic data processing device according to claim 1, wherein the offset derivation part calculates an index representing variance of distances from an offset to respective ones of true magnetic data that are obtained by subtracting each Δpᵢ from each magnetic data q₁ of the statistical population, and derives the offset which minimizes the expected value of the calculated index.

3. The magnetic data processing device according to claim 2, wherein the offset derivation part calculates the index in the form of a real-valued function fᵥ(c), and assuming that an expected value of the real-valued function fᵥ(c) is a function f(c), the derivation part obtains the function f(c) by substituting a term of the real-valued function fᵥ(c) containing the random variable v₁ which is time-independent, with its expected value corresponding to the probability distribution. µ and derives, as the offset, c which minimizes the function f(c).

4. The magnetic data processing device according to claim 3, wherein the real-valued function fᵥ(c) is expressed as follows: ${f}_{v} \left(c\right) = {c}^{T} \left({X}_{v}^{T}⁢{X}_{v}\right) ⁢ c - 2 ⁢ {\left({X}_{v}^{T}⁢{j}_{v}\right)}^{T} ⁢ c + {j}_{v}^{T} ⁢ {j}_{v}$
where $\overline{q} = \frac{1}{n} {\sum }_{i = 1}^{n} {q}_{i}$ $\overline{v} = \frac{1}{n} {\sum }_{i = 1}^{n} {v}_{i}$ ${X}_{v} = \left[\begin{matrix}{\left\{\begin{matrix}\left({q}_{1}-{v}_{1}\right) - \left(\overline{q}-\overline{v}\right)\end{matrix}\right\}}^{T} \\ ⋮ \\ {\left\{\begin{matrix}\left({q}_{n}-{v}_{n}\right) - \left(\overline{q}-\overline{v}\right)\end{matrix}\right\}}^{T}\end{matrix}\right]$ ${R}_{v} = \frac{1}{n} {\sum }_{i = 1}^{n} {\left({q}_{i}-{v}_{i}\right)}^{T} ⁢ \left({q}_{i}-{v}_{i}\right)$ ${j}_{v} = \frac{1}{2} ⁢ \left[\begin{matrix}{\left({q}_{1}-{v}_{1}\right)}^{T} ⁢ \left({q}_{1}-{v}_{1}\right) - {R}_{v} \\ ⋮ \\ {\left({q}_{n}-{v}_{n}\right)}^{T} ⁢ \left({q}_{n}-{v}_{n}\right) - {R}_{v}\end{matrix}\right]$

5. The magnetic data processing device according to claim 3 or 4, wherein, when A' is positive definite, the offset derivation part outputs, as the offset, c expressed as follows: $c = {Aʹ}^{- 1} ⁢ \left({X}^{T}⁢j-\left(n-1\right)⁢V⁢\overline{q}\right)$
or $c = {Aʹ}^{- 1} ⁢ {X}^{T} ⁢ jʹ + \overline{q}$
where $X = \left[\begin{matrix}{\left({q}_{i}-\overline{q}\right)}^{T} \\ ⋮ \\ {\left({q}_{n}-\overline{q}\right)}^{T}\end{matrix}\right]$ $R = \frac{1}{n} {\sum }_{i = 1}^{n} {q}_{i}^{T} ⁢ {q}_{i}$ $j = \frac{1}{2} ⁢ \left[\begin{matrix}{q}_{1}^{T} ⁢ {q}_{1} - R \\ ⋮ \\ {q}_{n}^{T} ⁢ {q}_{n} - R\end{matrix}\right]$ $Rʹ = \frac{1}{n} {\sum }_{i = 1}^{n} {\left({q}_{i}-\overline{q}\right)}^{T} ⁢ \left({q}_{i}-\overline{q}\right)$ $jʹ = \frac{1}{2} ⁢ \left[\begin{matrix}{\left({q}_{1}-\overline{q}\right)}^{T} ⁢ \left({q}_{1}-\overline{q}\right) - Rʹ \\ ⋮ \\ {\left({q}_{n}-\overline{q}\right)}^{T} ⁢ \left({q}_{n}-\overline{q}\right) - Rʹ\end{matrix}\right]$ $A = {X}^{T} ⁢ X$ $Aʹ = A - \left(n-1\right) ⁢ V$
where V is a variance-covariance matrix of the probability distribution µ.

6. The magnetic data processing device according to claim 2, wherein the offset derivation part calculates the index in the form of a real-valued function fᵥ(c) , and assuming that an expected value of the real-valued function fᵥ(c) is a function f(c), the derivation part obtains the function f(c) by substituting a term of the real-valued function fᵥ(c) containing the random variable,v₁ which is time-independent, with its expected value corresponding to the probability distribution µ, and derives, as the offset, c which minimizes the function f(c) under a constraint condition.

7. The magnetic data processing device according to claim 6, wherein the offset derivation part defines the real-valued function fᵥ(c) expressed as follows: ${f}_{v} \left(c\right) = {c}^{T} \left({X}_{v}^{T}⁢{X}_{v}\right) ⁢ c - 2 ⁢ {\left({X}_{v}^{T}⁢{j}_{v}\right)}^{T} ⁢ c + {j}_{v}^{T} ⁢ {j}_{v}$
where $\overline{q} = \frac{1}{n} {\sum }_{i = 1}^{n} {q}_{i}$ $\overline{v} = \frac{1}{n} {\sum }_{i = 1}^{n} {v}_{i}$ ${X}_{v} = \left[\begin{matrix}{\left\{\begin{matrix}\left({q}_{1}-{v}_{1}\right) - \left(\overline{q}-\overline{v}\right)\end{matrix}\right\}}^{T} \\ ⋮ \\ {\left\{\begin{matrix}\left({q}_{n}-{v}_{n}\right) - \left(\overline{q}-\overline{v}\right)\end{matrix}\right\}}^{T}\end{matrix}\right]$ ${R}_{v} = \frac{1}{n} {\sum }_{i = 1}^{n} {\left({q}_{i}-{v}_{i}\right)}^{T} ⁢ \left({q}_{i}-{v}_{i}\right)$ ${j}_{v} = \frac{1}{2} ⁢ \left[\begin{matrix}{\left({q}_{1}-{v}_{1}\right)}^{T} ⁢ \left({q}_{1}-{v}_{1}\right) - {R}_{v} \\ ⋮ \\ {\left({q}_{n}-{v}_{n}\right)}^{T} ⁢ \left({q}_{n}-{v}_{n}\right) - {R}_{v}\end{matrix}\right]$
wherein the storage part sequentially stores a plurality of the magnetic data in order to update an old offset of the magnetic data with a new offset, and
the offset derivation part derives the new offset based on the old offset and the statistical population under the constraint condition that the new offset be obtained as the sum of the old offset and a correction vector that is a linear combination of a set of fundamental vectors in principal axis directions of distribution of the statistical population, respective coefficients of the linear combination of the fundamental vectors being obtained by weighting, according to principal values of the distribution of the statistical population, respective coefficients of a position vector of a temporary offset, derived from the statistical population without using the old offset, relative to the old offset, the position vector of the temporary offset being a linear combination of the fundamental vectors.

8. A magnetic data processing method of processing magnetic data to determine an offset thereof, comprising:
an input process of sequentially receiving magnetic data q₁ output from a magnetic sensor;
a storage process of sequentially storing the magnetic data received by the input process; and
an offset derivation process of deriving an offset of the magnetic data according to a probabilistic method using a plurality of the magnetic data stored by the storage process as a statistical population,
wherein the offset derivation process assumes that an error Δp₁ contained in each of the plurality of the magnetic data is a random variable v₁ following a probability distribution µ and uses an expected value corresponding to the probability distribution µ for deriving the offset.

9. A magnetic data processing program allowing a computer to perform:
an input process of sequentially receiving magnetic data q₁ output from a magnetic sensor;
a storage process of sequentially storing the magnetic data received by the input process; and
an offset derivation process of deriving an offset of the magnetic data according to a probabilistic method using a plurality of the magnetic data stored by the storage process as a statistical population,
wherein the offset derivation process assumes that an error Apt contained in teach of the plurality of the magnetic data is a random variable v₁ following a probability distribution and uses an expected value corresponding to the probability distribution µ for deriving the offset.
